(19) Europäisches Patentamt
European Patent Office
Office européen des brevets

(11) **EP 1 714 317 B1**

(12) **EUROPEAN PATENT SPECIFICATION**

(45) Date of publication and mention
of the grant of the patent:
**28.05.2008 Bulletin 2008/22**

(51) Int Cl.:
***G02F 1/035*** (2006.01)    ***G02F 1/355*** (2006.01)

(21) Application number: **04736974.9**

(22) Date of filing: **17.06.2004**

(86) International application number:
**PCT/CH2004/000365**

(87) International publication number:
**WO 2005/067031 (21.07.2005 Gazette 2005/29)**

(54) **OPTICAL DEVICES COMPRISING THIN FERROELECTRIC FILMS**

OPTISCHE BAUELEMENTE MIT DÜNNEN FERROELEKTRISCHEN FILMEN

DISPOSITIFS OPTIQUES COMPRENANT DE FILMS FERROELECTRIQUES MINCES

(84) Designated Contracting States:
**AT BE BG CH CY CZ DE DK EE ES FI FR GB GR HU IE IT LI LU MC NL PL PT RO SE SI SK TR**

(30) Priority: **12.01.2004 EP 04000408**

(43) Date of publication of application:
**25.10.2006 Bulletin 2006/43**

(73) Proprietor: **Eidgenössische Technische Hochschule Zürich**
**8092 Zürich (CH)**

(72) Inventors:
• **GÜNTER, Peter**
**CH-8173 Riedt-Neerach (CH)**
• **RABIEI, Payam**
**Sunnyvale, CA 94086 (US)**

(74) Representative: **Frei, Alexandra Sarah**
**Frei Patentanwaltsbüro**
**Postfach 1771**
**8032 Zürich (CH)**

(56) References cited:
WO-A1-00/50938          US-A- 6 078 605
US-A1- 2002 039 470    US-A1- 2003 199 105
US-A1- 2003 223 695    US-B1- 6 195 187
US-B1- 6 540 827        US-B1- 6 593 212
US-B1- 6 661 950        US-B2- 6 563 153

• MALEVILLE C ET AL: "MULTIPLE SOI LAYERS BY MULTIPLE SMART-CUT TRANSFERS" 2000 IEEE INTERNATIONAL SOI CONFERENCE PROCEEDINGS, WAKEFIELD, MA, OCT. 2 - 5, 2000, NEW YORK, NY, IEEE, US, 2 October 2000 (2000-10-02), pages 134-135, XP001003462 ISBN: 0-7803-6390-6
• LITTLE B E; HAUS H A; FORESI J S; KIMERLING L C; IPPEN E P; RIPIN D J: 'Wavelength Switching and Routing Using Absorption and Resonance' IEEE PHOTONICS TECHNOLOGY LETTERS, IEEE SERVICE CENTER vol. 10, no. 6, June 1998, PISCATAWAY, NJ, US, pages 816 - 818, XP011046093
• SOREF R A; LITTLE B E: 'PROPOSED N-WAVELENGTH M-FIBER WDM CROSSCONNECT SWITCH USING ACTIVE MICRORING RESONATORS' IEEE PHOTONICS TECHNOLOGY LETTERS, IEEE SERVICE CENTER vol. 10, no. 8, August 1998, PISCATAWAY, NJ, US, pages 1121 - 1123, XP000769876

**Description**

FIELD OF THE INVENTION

The invention generally relates to applications of thin films of ferroelectric materials in integrated optical devices for telecommunication and data communication. In particular the invention relates to fabrication of thin films of nonlinear optical materials, and to integrated optical devices for amplification and switching of light-wave signals.

BACKGROUND OF THE INVENTION

Owing to large frequency-bandwidth of optical fibers, light-wave technology provides the ability to send a large amount of data using a very small fiber. To maximize the transmission capability of optical fibers one has to use wavelength division multiplexing (WDM) technology. The current long-haul communication systems use WDM technology for transmitting large amount of data over optical fibers.

To build an optical communication system using WDM technology one requires to generate, amplify, modulate, filter and detect optical signals with different wavelengths. To generate optical signals one needs to be able to amplify the optical signals. To modulate the optical signal one requires changing the refractive index of the material and using some optical circuit to modulate optical signals. To filter the WDM signals one need to use optical filters and finally one needs detectors for this purpose.

Generally these functions are performed with different technologies in optical communication systems. For example for generation semiconductor devices are used, for amplification erbium doped fiber amplifiers (EDFA) are used. For modulation $LiNbO_3$ Mach-Zehnder modulators are used. To filter the signals glass planar waveguide circuits are used. Finally for detection different semiconductors are used.

Since different technologies and materials are used, the WDM optical communication systems are usually very expensive and require a large space.

For waveguide circuits and for integrated optical devices, owing to large nonlinear coefficient for ferroelectric crystals such as $LiNbO_3$ and $LiTaO_3$ and $KNbO_3$ are desirable to fabricate thin films with high quality. For the fabrication of thin films several methods have been used in the past. Molecular beam epitaxy, plasma sputtering, Laser pulse deposition and some other methods have been used in the past. However the thin films obtained by these methods have two main problems. First the films can be grown on special substrates, which provide lattice matching to the crystal. This will limit the fabrication process to very few cases and one cannot achieve optical waveguides with desirable properties. Second the quality of the fabricated films is not as good as bulk crystals. The optical losses are very high and the electro-optic coefficient is very small. A good method for the fabrication of thin films of ferroelectric crystals with high quality does not exist.

The current devices based on the ferroelectric crystals use bulk crystals and they form a low index contrast waveguide in the crystal by ion exchange or diffusion to form an optical waveguides. Switching of the light is achieved in these devices by changing the refractive index of the material by applying an electric field to the waveguide. Also optical amplification is achieved by use of three wave mixing in these crystals. To achieve phase matching periodic poling is used. The devices for switching and modulation are very big (up to 2cm long) and the devices for amplification are very long and have small bandwidth.

US 6,593,212 discloses a method for transferring an electro-optical layer grown on a growth substrate to a handle substrate and fabricating optical devices such as an optical switch using the layer transfer technique.

SUMMARY OF THE INVENTION

It is the general object of this invention to fabricate thin films of nonlinear optical crystals for the fabrication of nonlinear optical devices to be used for generation, modulation, amplification and filtering of light-wave signals.

It is another object of the present invention to introduce new devices, which can be made using the thin films of optical nonlinear materials for amplification, modulation, filtering of lightwave signals.

It is a still further objective of the present invention to provide new optical communication systems that can be made using the proposed technology.

These objects are achieved by an optical device and an integrated optoelectronic device as defined in the claims.

A method of producing a device with a ferroelectric crystal thin film on a first substrate comprises the steps of providing a ferroelectric crystal, of irradiating a first surface of said ferroelectric crystal with ions so that a damaged layer is created underneath said first surface, of bonding a block of material including said first substrate to said ferroelectric crystal to create a bonded element, wherein an interface is formed between said first surface and a second surface of said block, and of heating the bonded element and separating it at the damaged layer, so that a ferroelectric crystal layer remains supported by the first substrate. By this method, very thin films - down to thicknesses a fraction of a micrometer - of ferroelectric crystals may be fabricated without jeopardizing the monocrystalline structure.

Prior to bonding the block to the second substrate, the first substrate is preferably provided with a electrode layer prior to the bonding. This solves the additional problem of finding ways to apply voltages to such a thin ferroelectric crystal layer: In addition to the electrode layer - which may or may not be structured - a top electrode may be placed, so that the ferroelectric layer - including possible cladding layers - is sandwiched between two electrodes. This opens the possibility of specifically using electro-optic, piezoelectric, pyroelectric etc. effects of the ferroelectric material. Specifically, by influencing the index of refraction of a small waveguide, one can achieve switching functionalities.

In this way, a technology is introduced, which can provide all the functions required for integrated optoelectronic devices - including amplification - in a single material. Also using this technology it is possible to reduce the size of optical devices by factors of 100 to 1000. Since the size is reduced and all the required functions are made in a single material system the price of integrated systems can be reduced significantly.

An integrated optoelectronic device may include a parametric amplifier comprising a waveguide with a core comprising at least two layers of differently, preferably opposed, poled ferroelectric material. If the interface between such layers is placed at a node of a higher order waveguide mode, the overlap integral between the basic mode and the higher order mode may become large. This is a prerequisite of parametric amplification or frequency doubling being possible with a high efficiency.

A further advantage of the method of producing a device is that the index of refraction of ferroelectric materials is comparably high. For this reason, a high index contrast between a waveguide core and a cladding may be achieved, which allows both, waveguide bending with small radius and high energy densities beneficial for optically nonlinear effects.

Since the WDM communication system can be made in a very compact way it is also possible to use the system for data communication. The speed of the computers are now limited by the speed of the communication of signals between different modules in a computer. Using the described technology it is possible to use light-wave signals inside a computer to transmit the data much faster than printed circuit boards currently used.

The wavelengths for which waveguides according to this invention are preferably designed, are the wavelengths preferred by the WDM technology, mainly frequency windows around 850 nm, 1300 nm, and 1550 nm. (for example $\pm$ 50 nm around each of these center frequencies). However, the invention is by no means restricted to these frequency windows.

The technology introduced is based on the fabrication of thin films of optical materials with large nonlinear coefficients, i.e. ferroelectric thin films.

In fact, it is one of the important achievements of this invention that electrodes adjacent to both sides of a very thin ferroelectric layer become readily feasible.

BRIEF DESCRIPTION OF THE DRAWINGS

The above and still further objects, features and advantages will become apparent upon consideration of the following detailed description of specific embodiments thereof. The description refers to drawings, in which the figures show:

Fig.1: The fabrication process for preparation of thin films of LiNbO$_3$ on SiO$_2$ cladding layers.

Fig. 2: An image for the fabricated LiNbO$_3$ waveguide

Fig. 3a: The cross section of a channel waveguide.

Fig. 3b: The cross sections of a ridge waveguide.

Fig. 4 The cross section along the propagation direction for a periodically poled ferroelectric waveguide (upper panel; the arrows indicate the direction of domains), and the electrode structure for periodically polling the ferroelectric waveguide (lower panel).

Fig. 5a and 5b: Multi-layer waveguides that can be fabricated by repeating the fabrication process invented with crystals with different spontaneous polarization direction vectors.

Fig. 6: A multi-layer LiNbO$_3$ waveguide with modulated nonlinear susceptibility direction

Fig. 7: Chromatic dispersion calculated for bulk crystal of LiNbO$_3$ and the calculated chromatic dispersion for different waveguide configuration. The chromatic dispersion can be forced to zero at the 1.55mm wavelength by a careful choice of the refractive index of the cladding of the waveguide.

Fig. 8: Calculated gain spectrum for parametric amplification for different cladding index for $LM_0^- \rightarrow LM_2^-$ conversion for different refractive index of cladding for a LiNbO$_3$ waveguide.

Fig. 9: A Mach-Zehnder modulator structure.

Fig. 10: A micro-ring modulator (switch) structure with coupling waveguides.

Fig. 11: The modulation (switching) of light by shifting the resonance wavelength in an electro-optic micro-resonator.

Fig. 12: A Mach-Zehnder modulator with electro-optic micro-ring resonators coupled to different arms.

Fig. 13: The transmission of the micro-ring coupled Mach-Zehnder structure for different values of the phase difference induced by shifting the resonance wavelengths of the micro-resonators.

Fig. 14: A multi-wavelength modulator (Switch), which uses several micro-resonators with different resonance wavelength.

Fig. 15: A wavelength router, which can route any input wavelength in any input port to any output port.

Fig. 16: A high order filter realized by coupling micro-resonators with different coupling coefficients to different arms of a Mach-Zehnder switch.

Fig. 17: A multi-wavelength switch comprising high order filters for each wavelength.

Fig. 18: An electrode structure for coupling the light of the micro-ring structure for inducing losses in the micro-resonator structure.

Fig. 19: The calculated losses for periodic modulation of refractive index in a micro-resonator as a function of number of periods of electrodes .

## DESCRIPTION OF THE PREFERRED EMBODIMENTS

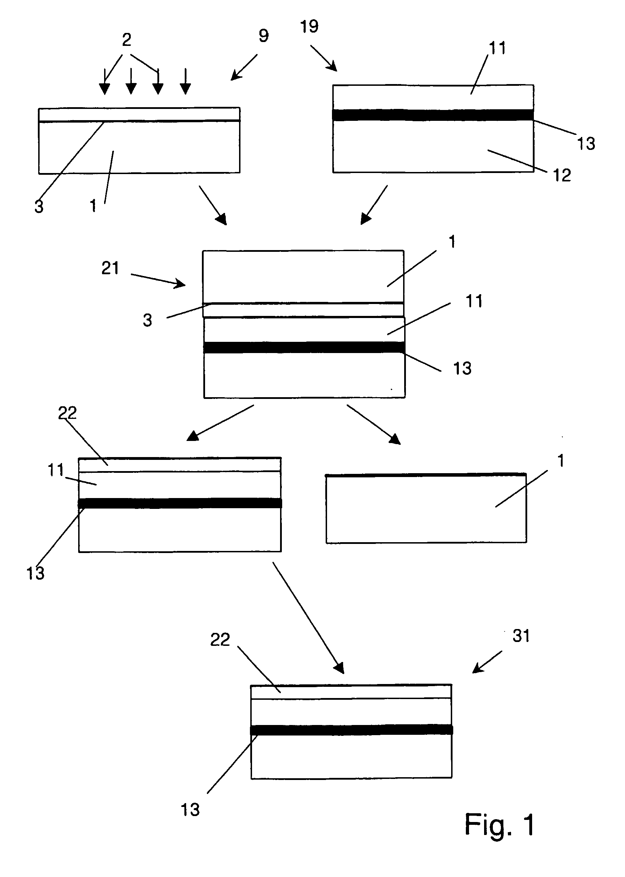

**Fig.1** shows a basic procedure, which is used for the fabrication of thin films of nonlinear optical crystals. As is shown in Fig.1, first a LiNbO$_3$ ferroelectric crystal 1 is ion implanted using ionized He+ ions 2. The He+ ions are accelerated in an electric filed and are used to bombard the ferroelectric crystal. The energy for these ions varies between 50keV to 1Mev. Because the He+ ions penetrate into the crystal, a damaged layer 3 is formed inside the crystal. In this layer the bonding between the adjacent atoms is broken due to the presence of the He atom.

The ferroelectric crystal is a bulk crystal (as opposed to grown layer films). Bulk crystals in this context are crystals that do not rely on a support (or growth) substrate and the size of which usually exceeds 100 $\mu$m in all three dimensions. Bulk crystals may be fabricated from the melt using a seed and are usually cheaper and in much better quality than grown films.

As an alternative to He+ ions, Hydrogen ions or other ions my be used. The nature and the energy of the ions determines the final thickness for the thin film fabricated using this method. The thickness may be tailored between 0.1 $\mu$m and 2.5 $\mu$m and is usually chosen to be in the range between 0.25 $\mu$m and 1 $\mu$m for integrated optic applications.

A layer of SiO$_2$ 11 is deposited on another LiNbO$_3$ substrate 12, for example using plasma enhanced chemical vapor deposition system. This layer 11 will behave as a buffer layer or a cladding for an optical waveguide to be fabricated. The thickness of this layer can be between a few nanometers (for example 5 nm) up to 2-5 micrometers. The thickness of this layer may be optimized according to the thickness of the core layer (i.e. the ferroelectric crystal layer to be fabricated) to minimize the coupling of the light to the LiNbO$_3$ substrate for integrated optic applications. A thin film polishing (CMP polishing) technique may be applied to smoothen the surface of the deposited SiO$_2$ layer.

This other substrate - also called 'first substrate' in this application - may as an alternative to being a ferroelectric crystal be made of any substrate material, for example a semiconductor such as Si, a metal etc. It may - depending on the application - also be a glass. 'Conventional' substrates such as Si or glass feature the advantage that they are comparably low in cost, whereas a substrate of the ferroelectric material of the layer has the same coefficient of thermal expansion, so that stress upon the crystal layer during heating steps can be ruled out. The first substrate can also carry an integrated electronic circuit, which might be used to apply the appropriate voltage to the fabricated photonic system made by the said fabrication method.

As on option, previously to being provided with the buffer layer 11, the first substrate 12 may be provided with an electrode layer 13. The electrode layer is an electrically conducting layer, for example of a metal such as copper or any other pure metal or metal alloy or doped semiconductor layer such as doped silicon. It has a thickness enabling it to conduct electricity, for example a thickness of 100 nm.

As an alternative to the above procedure, the electrode layer and/or the buffer layer could in principle also be provided on the crystal which then is bonded to the first substrate. To this end, the buffer layer is added to the crystal surface, and then optionally the electrode is provided on top of the buffer layer. The block of material comprising the first substrate is then bonded to the electrode layer or the buffer layer, respectively. However, by providing the electrode layer and the buffer layer on the first substrate as shown referring to Fig. 1, one can avoid having to grow these layers on the nonlinear crystal material later to become the core layer. This is advantageous since said crystal material is often delicate.

The resulting ion implanted sample 9 and the sample with cladding layer 19 are bonded together, using standard wafer bonding techniques. To achieve this, the samples are cleaned using the organic solvents and using an RCA1 solution that activates their surface. The samples are brought into contact inside de-ionized water and are pressed against each other to form a bond between them. The samples will attach to each other after this process. Next, the resulting bonded element 21 is heat treated to increase the bonding strength and to split and transfer a thin layer of the crystal. It is placed in an oven at temperatures between 100°C and 600°C for at least half an hour, for example at 250°C for 20 hours. A thin layer of crystal 22 - to be the core layer - is thereby transferred to the other substrate 12. Hence one will obtain a thin layer of the ferroelectric crystal 22 using this method. A final product 31 can be further improved by a further annealing and final polishing. Starting from such a final product the ferroelectric crystal may be structured to serve as a waveguide core of a laterally confined ("3d"-) waveguide or an otherwise structured element.

The buffer layer may, for some embodiments, be omitted. For example, the ferroelectric layer may be bonded directly to the electrode.

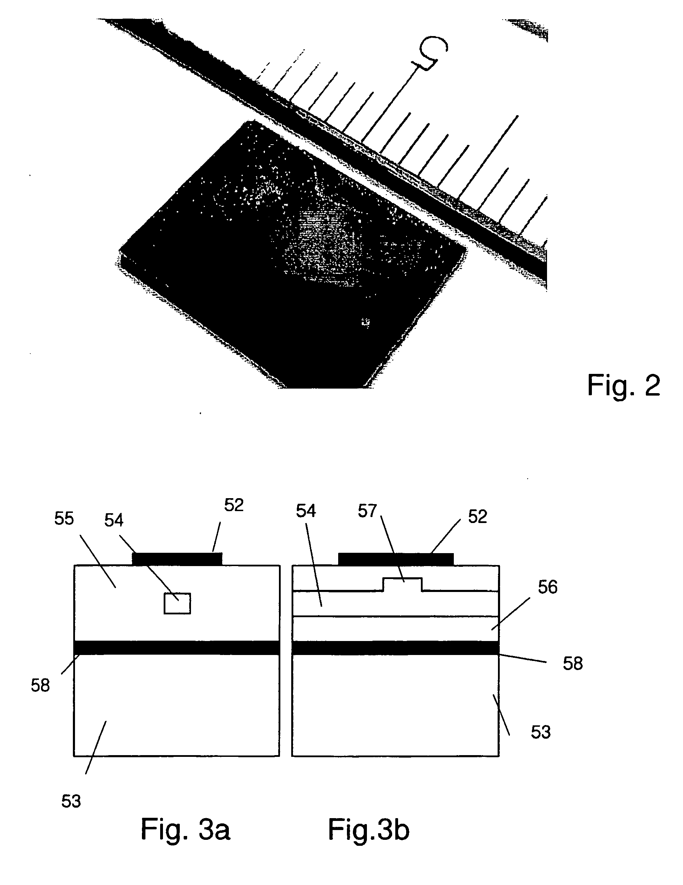

**Fig.2** shows a picture of a thin LiNbO$_3$ crystal film, which has been made using the described technique. The film is essentially homogeneous and monocrystalline. Since the thin film is directly fabricated from a bulk ferroelectric crystal it has the optical properties of a bulk crystal. Hence the optical losses are very small and the measured electro-optic coefficient is very high.

Next, devices comprising thin ferroelectric crystal layers are described. The ferroelectric crystal layers are fabricated using the above method (the electrode being only present in some embodiments, as described). The ferroelectric crystal layers may be of LiNbO$_3$, of LiTaO$_3$, of KNbO$_3$, or of any other suitable optically ferroelectric crystal material. The vertical confinement of the light is achieved by total internal reflection from the upper and lower cladding in the core of the waveguide fabricated. A lateral confinement of light is achieved by selectively pattering the thin film fabricated using optical or electron beam lithography and plasma etching. The lateral confinement might be strong as shown in **Fig.3a** or weak as shown in **Fig.3b.** For a weak confinement only a small part of the core is removed by plasma etching of the ferroelectric crystal. For strong confinement the whole core layer - except at the position of the waveguide - is removed by plasma etching. In the structure of Fig. 3a, the ferroelectric material 54 is laterally confined and is surrounded by cladding material 55, whereas in the structure of Fig. 3b it is provided as a layer that is laterally not confined. In the structure of Fig. 3b, lateral guiding of the lightwaves is accomplished by a thickness of the ferroelectric layer 54 that does not allow plane waves to develop and by a ridge 57 of a material with an index of refraction equal or similar to the one of the ferroelectric layer. In both figures, both, the lower electrode 58 fabricated by the method described above and the laterally structured top electrode 52 are shown.

The top electrode 52 shown in Fig. 3 may be fabricated at the device surface using any known technique for selectively depositing a metal including techniques involving masks, photolithography and etching techniques etc..

First we consider optical amplification. To achieve an optical amplifier in a nonlinear optical crystal one has to convert a photon from a strong optical pump signal through nonlinear interaction into two photons, one in the signal wavelength and one in the idler wavelength. The optical signal frequency of the pump and the signal and idler obey the following energy conservation equation:

$$\omega_p = \omega_i + \omega_s \qquad\qquad (1)$$

To achieve a practical amplifier one needs the phase matching condition to be fulfilled. The phase matching is given by:

$$n(\omega_p)\omega_p = n(\omega_s)\omega_s + n(\omega_i)\omega_i \qquad\qquad (2)$$

Therefore, the effective index of different guided modes in a ferroelectric crystal waveguide has to be matched.

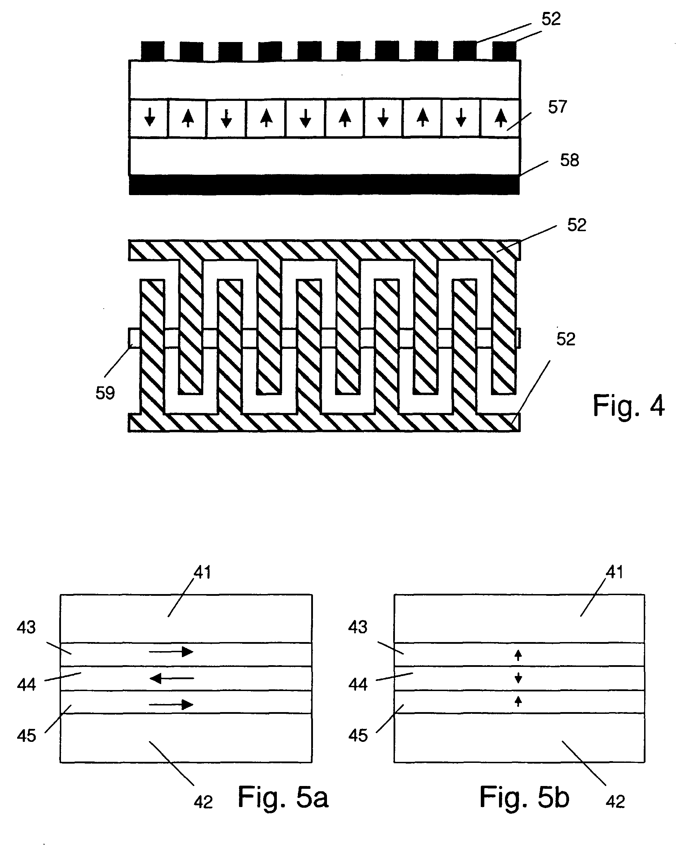

Two methods are introduced in the current disclosure to achieve phase matching in the described nonlinear waveguide, which can be fabricated by the method disclosed before. First one can use the "quasi phase matching method" in which in the fabricated nonlinear waveguide the direction of the spontaneous polarization is reversed in half-length of the coherent length which is the length in which the guided mode for idler, signal and frequency became out of phase. This technique is widely known as quasi-phase matching and has been applied to bulk crystals. Similar method can be used for efficient second harmonic generation and parametric amplification for the described nonlinear waveguide. For this purpose the top electrode layer 52 is patterned periodically after the fabrication of the waveguide, which can be a ridge or channel waveguide as shown in **Fig. 4**. The period for the electrodes 52 depends on the desired wavelength and can be between $1\mu m$ to several 10s of micrometers. As an example for an amplifier at $1.55\ \mu m$ band one need an electrode spacing of $2\ \mu m$. Next the nonlinear material is poled by applying a voltage to the electrodes. The poling is very simple in this case as compared to the bulk crystal case since one can apply fields higher than the coercive filed of the nonlinear material and immediately switch the domains. In Fig. 4, the waveguide is indicated by reference numeral 59.

A second method which can be used for phase matching using the described nonlinear waveguide is the effective index phase matching. In this method the effective index of the signal and idler guided modes are made equal to effective index of a higher order mode at pump frequency. Since the refractive index of the material increases with the frequency $\omega$ it is only possible to match fundamental mode at idler and signal frequencies with higher order modes at pump frequency.

However the overlap integral between modes with different orders is normally small or zero. The overlap integral for mode conversion is:

$$S = \int d(x,y)E_m^{(\omega_p)}(x,y)(E_n^{(\omega_s)}(x,y)E_n^{(\omega_i)}(x,y))dxdy \qquad (3)$$

where E is the electric field for the guided mode and d is the nonlinear susceptibility and $x$ and $y$ are the Cartesian coordinates and m and n ore mode orders. Since different guided modes are orthogonal, the overlap integral is small or zero. However if the sign of $d$ in equation (3) is changed when the mode sign for the $E^{(\omega p)}$ - the more rapidly varying electric field - changes, the overlap integral will be large. An example of a core structure for a parametric amplifier is depicted in **Fig. 5a and 5b**. The structure comprises, between two layers 41, 42 of cladding material - for example $SiO_2$ - three ferroelectric crystal layers 43, 44, 45 with different directions of their spontaneous polarization. The center layer 44 has a direction of spontaneous polarization that is opposed to the direction of the spontaneous polarization of the outer layers 43, 44. In Fig. 5a, the layers are polarized in-plane, whereas Fig. 5b shows an example of an out-of-plane polarization of the layers. Since the direction of spontaneous polarization (and hence d in Formula 3) changes the overlap integral is maximized using this configuration. The structures of Figs. 5a and 5b may be produced by repeating the method described above with crystals with different directions of their spontaneous polarization vector.

In the following, it is explained why this type of structure is very useful for nonlinear optical wave mixing. This is the case for the structure of Figs. 5a and 5b.

Whereas the structures shown in Figs. 5a and 5b and also in the figure described further below comprises three layers of opposing polarization, instead of three layers also two layers or more than three layers may be chosen. The important thing is that the sign of the susceptibility changes approximately when the sign of the $E^{(\omega p)}$ changes.

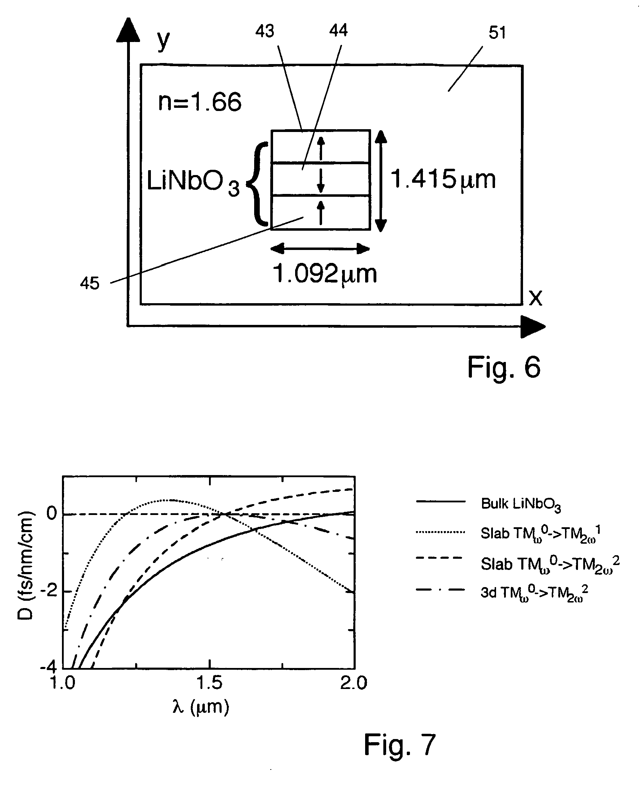

An example of a amplifier structure that is adjusted for a wavelength of $1.55\mu m$ - a telecommunication wavelength - is shown in **Fig. 6.** In Fig. 6, the optically nonlinear layers 43, 44, 45 are laterally confined. The lateral confinement of the layers can be made based on a structure as in Fig. 5b (without topmost cladding layer 41) by standard photolithography and etching structuring techniques which are not subject of the invention and will not be described in any detail here. The amplifier structure of Fig. 6 comprises a cladding 51 surrounding the three optically nonlinear layers. The cladding - the index of refraction may be adjusted as described in more detail below - may be for example a Silicon oxide fabricated by PE-CVD. The dimensions of the cladding in x and y direction - referring to the coordinate system drawn in the figure - are not critical.

The structure in Fig. 6 comprising LiNbO$_3$ as optically nonlinear material and comprising the ferroelectric material dimensions shown in the Figure is designed as to maximize the overlap integral *S* for phase matching the fundamental TM mode at $\omega_i$ and $\omega_s$ to the second mode of TM mode at $\omega_p$ using e.g. d$_{33}$ of LiNbO$_3$ in a 3D waveguide at 1.55$\mu$m. A "3D waveguide" in this context is a waveguide that is laterally confined in both directions, as opposed to a 2D waveguide or "slab" waveguide that is only confined vertically in one direction and is formed along a plane. d$_{33}$ denotes the y component of the susceptibility, y being normal to the propagation direction in the 3D waveguide The gain coefficient for parametric amplifier is given by:

$$G = \frac{1}{4}\exp(2\sqrt{\eta P_{pump}}L) \qquad (4)$$

where $\eta$ is the second harmonic conversion efficiency (being related to the gain for parametric amplification), L is the length of the amplifier and $P_{pump}$ is the pump power. The nonlinearity (conversion efficiency) for $TM_0^\omega \rightarrow TM_2^{2\omega}$ is as high as $\eta$=3000%/Wcm$^2$ for LiNbO$_3$ at 1.55$\mu$m. Considering this calculated efficiency and assuming a pump power of $P_{pump}$=300mW and *L=1cm* one can obtain G as high as 20dB.

To achieve a good amplifier it is necessary to achieve large bandwidth as well as high gain. In parametric amplification the required phase matching is written as:

$$n(\omega_p)\omega_p = n(\omega_s)\omega_s + n(\omega_i)\omega_i \qquad (5)$$

where *p, s* and *i* are pump, signal and idler frequency respectively. If the effective index is a linear function of the wavelength (i.e. if the dispersion of the waveguide is zero) the phase matching can be achieved over a large wavelength range.

The effective refractive index is a function of both the material dispersion and the waveguide dispersion. So in general the effective refractive index is a complicated function of the wavelength. One can approximate the effective index using the Taylor series expansion:

$$n(\lambda) = n(\lambda_0) + \frac{dn(\lambda)}{d\lambda}(\lambda - \lambda_0) + \frac{d^2n(\lambda)}{d\lambda^2}(\lambda - \lambda_0)^2 + ... \qquad (6)$$

So if the second derivative of the effective refractive index with respect to wavelength is zero and higher order term are negligible then the effective index is a linear function of the wavelength and the phase matching condition will be achieved over a large wavelength range. Notice that this is identical to the condition of making the chromatic dispersion equal to zero in an optical fiber for high-speed transmission of signals:

$$D(\lambda) = -\frac{\lambda}{c}\frac{d^2n_e}{d\lambda^2} = 0 \qquad (7)$$

where *D(λ)* is the chromatic dispersion (CD). Normally in electro-optic crystals this condition is not satisfied for the material dispersion. **Fig.7** shows the CD as a function of the wavelength for an LiNbO$_3$ crystal (solid curve). As it can be seen this function is always negative in the visible and the infrared wavelengths of interest. It is therefore impossible to satisfy phase matching over a long wavelength range using bulk crystal. However if one calculates the CD of a waveguide mode one will get wavelength regions, where the CD is positive. Therefore these two effects can cancel each other and it is possible to achieve zero CD at a desired wavelength. This is again identical to shifting of the zero of chromatic dispersion by carefully designing the fiber. Notice that now we require two condition to be satisfied at the same time. First, one needs to satisfy the phase matching condition at a given wavelength and second, one needs the CD to go to zero. This can be achieved by changing both the refractive index of the cladding and the core thickness. Thus, using the channel (3d) waveguide as described above it is possible to achieve zero dispersion as opposed to the bulk case, which is another advantage for the waveguides fabricated. This structure is made by using the method described above for the fabrication of thin films and by deposition of the glass material with adjusted refractive index using PECVD method for the cladding layers.

Methods and computer programs for carrying out calculations of optical quantities such as the chromatic dispersion depending on dimensions, indexes of refraction etc are known and are not described in any detail here. A commercially available computer program is for example a software named 'Selene' by the company C2V.

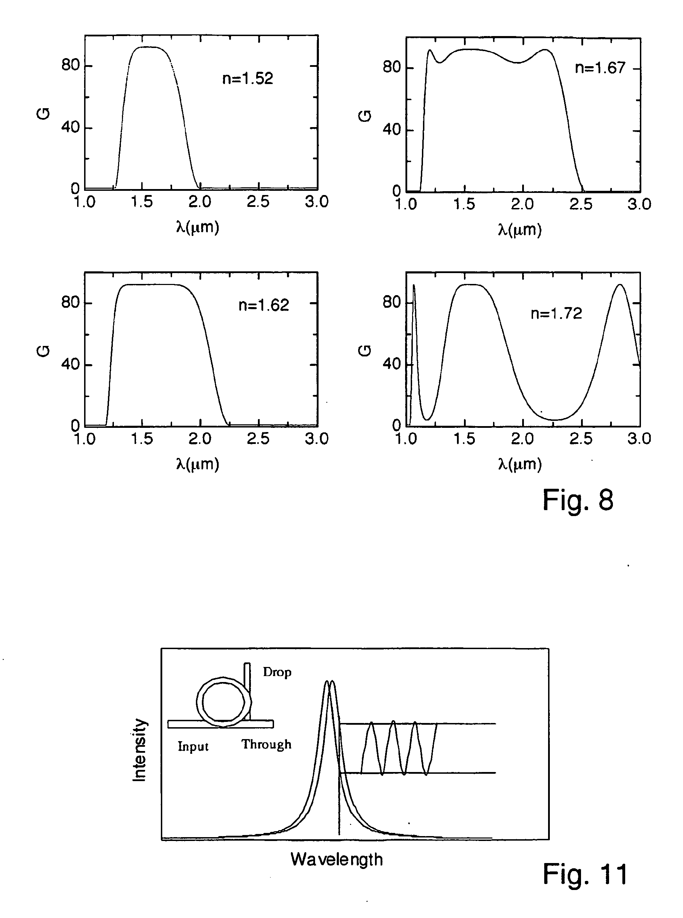

As an example consider the design of a parametric amplifier at 1.55$\mu$m using LiNbO$_3$. To design the right structure we obtain the right thickness, which satisfies the phase matching condition for each cladding refractive index. Next we calculate the dispersion. Table 1 summarizes the calculated waveguides thickness and cladding indices, which satisfy the phase matching condition and no dispersion for slab and 3d waveguides of LiNbO$_3$. The dispersion can be forced to become zero at the wavelength of 1.55$\mu$m for both TE and TM modes of 3d waveguides (and, practically less importantly, for TM slab waveguide, too, whereas the dispersion cannot be forced to zero for the TE mode of a slab waveguide of LiNbO$_3$ for practical numbers for the refractive index of the cladding). Fig.7 also shows the dispersion as a function of wavelength for the designs in Table 1 as a function of wavelength. Notice that for 3D waveguides one has an extra degree of freedom for choosing the aspect ratio of the waveguide. This is used for polarization independent phase matching. The amplification gain spectrum for the slab waveguide is plotted in **Fig.8** for $TM_0^{\omega} \rightarrow TM_2^{2\omega}$ - corresponding to the dashed line in Fig. 7 - conversion for different refractive indices n of the cladding. As it can be seen the gain spectrum is very wide (over 500nm).

Table 1: The calculated thickness and refractive index of the cladding to achieve phase matching and zero chromatic dispersion for different conversion schemes:

| | Core Thickness ($\mu$m) | Cladding refractive index | Width (3d) ($\mu$m) | Dispersion (fs/nm/cm) |
|---|---|---|---|---|
| Slab $TM_0^{\omega} \rightarrow TM_1^{2\omega}$ | 0.728 | 1.48 | - | 0 |
| Slab $TM_0^{\omega} \rightarrow TM_2^{2\omega}$ | 2.045 | 1.6 | - | 0.027 |
| | 2.044 | 1.62 | - | 0 |
| | 2.042 | 1.64 | - | -0.036 |
| | 2.041 | 1.66 | - | -0.07 |
| 3d TM $TM_0^{\omega} \rightarrow TM_2^{2\omega}$ | 1.577 | 1.75 | 1.492 | 0 |
| | 1.415 | 1.66 | 1.092 | 0 |
| 3d TE $TE_0^{\omega} \rightarrow TE_2^{2\omega}$ | 1.275 | 1.66 | 1.067 | 0 |

A second issue is the coupling the light into the structure. Notice that it is potentially difficult to excite a higher than fundamental mode of the waveguide. A better method can be to generate the pump by second harmonic generation. Then, next to the signal, also a primary pump radiation of a frequency $\omega_{pr}$ is coupled into the waveguide. The pump for the parametric amplification is the frequency doubled radiation with $\omega_p = 2\omega_{pr}$. The signal may be in a frequency band below the primary radiation, in a frequency band above the primary radiation or in a combination thereof. According to an embodiment, the frequency of the primary radiation is chosen within or at the border of the frequency band of the signal. Then, if the phase matching condition is satisfied for the signal in the entire frequency band, it is also satisfied for the case in which $\omega_s = \omega_i (= \omega_{pr})$. Therefore, the phase matching condition for frequency doubling is automatically satisfied. A numeric example: If the primary pump radiation has a frequency corresponding to a free space wavelength of $\lambda=2\pi c/\omega_{pr}=1600$ nm, the pump radiation has $\lambda=800$ nm, and the amplifier may amplify anything in the frequency range between 1600 nm and 1300 nm (assuming that the chromatic dispersion is zero in this range). This method has previously been demonstrated for periodically poled $LiNbO_3$ waveguides.

Notice that for this type of parametric amplifier one requires a large refractive index difference between core and cladding. Such a large difference has several advantages. First, the waveguides are small. This means that the intensity will be larger for a given power and hence the parametric gain will be high. Secondly since the waveguides cores have a large refractive index difference compared with the cladding, one can make micron-sized bends. Spiral amplifiers for example can be realized for reduced size optical elements. Consider that the 1cm length waveguide can be made into a spiral with 500$\mu$m diameter for example. Thirdly one can change the width of the waveguides or the period for the electrodes to achieve phase matching at different wavelengths. This means that in a single chip it is possible to extend the amplification wavelength. Fourthly the noise figure of this type of amplifier is basically the quantum limited noise of 3dB in phase-insensitive modes and also the noise figure can be made equal to zero in phase-sensitive modes.

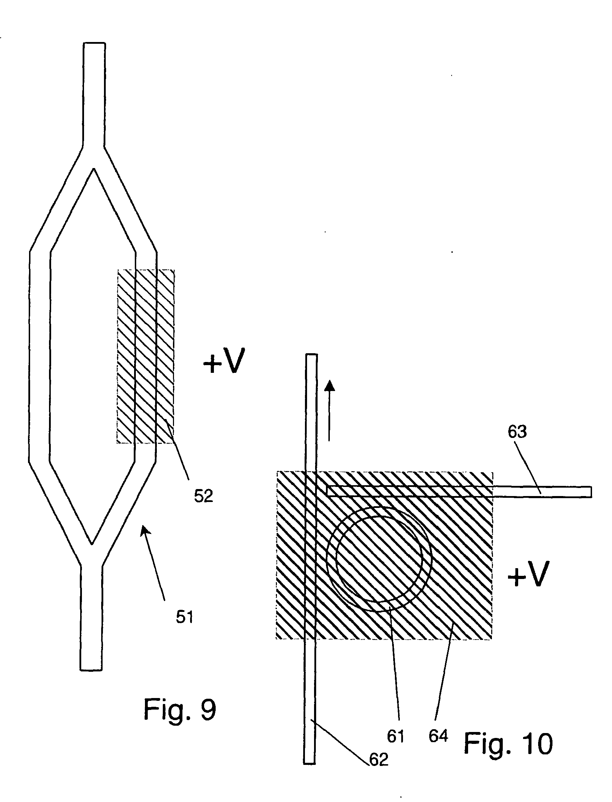

The thin films of nonlinear optical materials can also be used for the fabrication of optical switching devices and modulators. To achieve an optical switch, one needs to use a nonlinear optical material in an optical circuit. Since the refractive index of the fabricated thin film is very high compared to the cladding layer, one can make very small bends. So one can make optical devices with sizes as small as a few micrometers. The following devices can be made using the thin films of ferroelectric crystals for switching of light. The simplest device is a Mach-Zehnder modulator 51 as shown in **Fig. 9**. The modulator comprises two waveguide branches (or arms). In this device applying a voltage to the device on the electrode 52 influencing only one branch changes the refractive index of said branch. The phase of transmitted light changes and due to interference the output light intensity will be modulated according to the applied voltage. By using a 3dB coupler for coupling the incoming waveguides and the outgoing waveguides one can achieve switching.

Optical devices which are embodiments of the present invention will now be described.

The first device according to the invention is an electro-optic micro-ring resonator as shown in **Fig.10.** The light is coupled to the micro-resonator 61 from the input straight waveguide 62 and from the output straight waveguide 63. Due to the resonance the light transmitted from the input waveguide to the output waveguide as a function of the wavelength shows a resonance peak at the resonance frequency of the ring resonator. The light transmitted to the output waveguide (or "drop channel" is plotted as a function of the wavelength in **Fig. 11** (right curve). The remainder of the intensity is transmitted straight trough the input waveguide ("through channel"). Using the fabricated thin films as described before the refractive index of the micro-resonator may be changed by applying a voltage to the electrode 64 of the device. This will shift the resonance wavelength as shown in Fig. 11 (left curve). Hence one can modulate or switch a wavelength close to the resonance wavelength as shown by the right inset in Fig. 11.

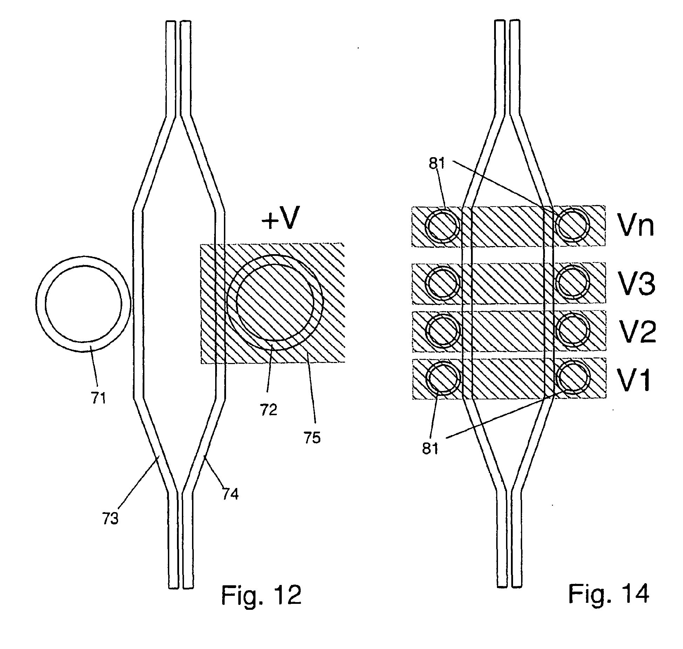

The next device is a wavelength selective switch in which two micro-resonators 71, 72 are coupled to two arms 73, 74 of a Mach-Zehnder modulator as shown in Fig. 12. On both, the input side and the output side, the arms 73, 74 are coupled by a 3dB coupler. Notice that the phase of the light changes close to the resonance wavelength of a micro-resonator in a single micro-resonator coupled to a waveguide. Hence by making a structure as shown in Fig. 12 comprising an electrode 75 and by poling the nonlinear core crystal of the micro-resonators in a push-pull fashion, and applying a voltage to the electrodes of the device one can modulate the transmitted light. The poling in a push-pull fashion may be realized by applying opposite voltage to the micro-resonator. The voltage must be such that the electric field is higher than the coercive field of the ferroelectric crystal, so that the spontaneous polarization or domains will switch to different directions for the two micro-resonators. As an alternative (with an electrode configuration different to the one shown in the drawing), the spontaneous polarization may be essentially identical in both micro-ring resonators, and the micro-ring resonators may comprise two electrodes and opposite voltage might be applied to them.

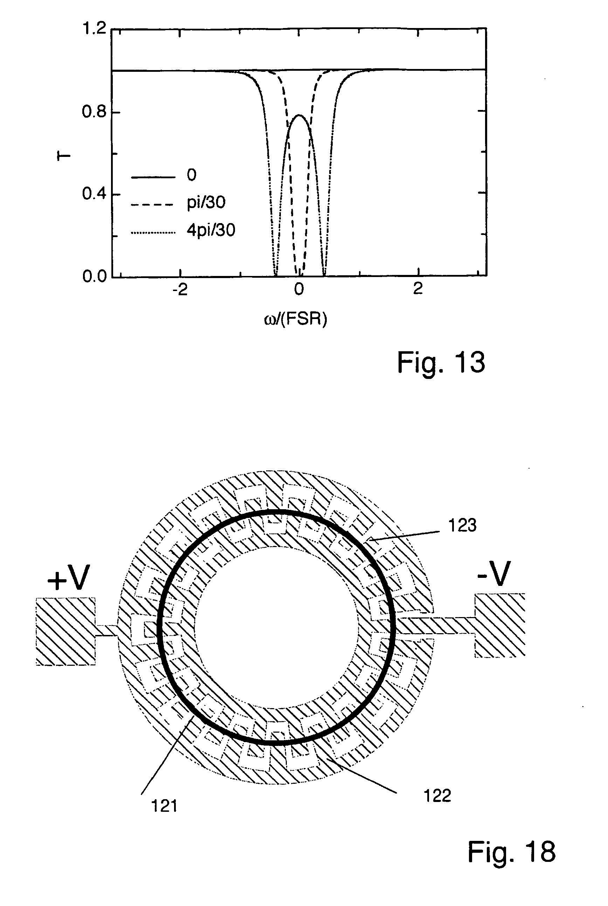

By shifting the resonance wavelength of the micro-resonators in different direction, the phase of the transmitted light will change and similar to a Mach-Zehnder device the light will be switched. Notice that this is very similar to a Mach-Zehnder modulator. However, this structure is wavelength sensitive. The light wavelength must be close to the resonance wavelength of the resonator to achieve modulation. The transmission for this modulator as a function of wavelength for different values of phase difference induced by electro-optic effect is shown in **Fig. 13**. There, the transmission through one branch is shown as a function of the difference between the frequency and the resonance frequency in units of the free spectral range (FSR). The solid curve shows the case where no voltage is applied and there is no phase difference between the branches. The dashed curve shows a case where the voltage is such that there is a phase difference between the branches of $\pi/30$, whereas the dotted curve corresponds to a phase difference of $4\pi/30$.

Notice that in the micro-ring modulator the switching is achieved by shifting the resonance wavelength of the device. Hence if one wavelength is switched on, the adjacent wavelength will switch off. However in the Mach-Zehnder based switches one can simply turn on a single wavelength or turn off the desired wavelength. This is very useful for the applications that we will discuss. Also the Mach Zehnder based device is two times more sensitive to the applied voltage if it is made in a push-pull fashion. Finally it is shown that any desired transfer function can be fabricated using two all pass filters in a Mach-Zehnder structure. Hence one can make higher order switches simply by adding more resonators coupled to the waveguide.

Many applications can be considered for the wavelength selective switches introduced. One can consider for example a multi-wavelength modulator as shown in **Fig. 14.** This structure comprises a plurality of pairs of micro-rings 81 (in the figure, only four pairs 1, 2, 3, and n are shown). Each pair of micro-rings has a different, given resonance wavelength and is adjusted close to resonance at that given wavelength. Hence they will only modulate the desired wavelength and pass the rest unaffected. So it is possible to modulate different wavelengths in a small single chip. Using practical devices one can modulate up to 100 different wavelengths as speed of 10Gbit/sec. Hence it is possible to transfer about 1Tbit of data in a single waveguide to the optical signal. This can be used for computer interconnect for example.

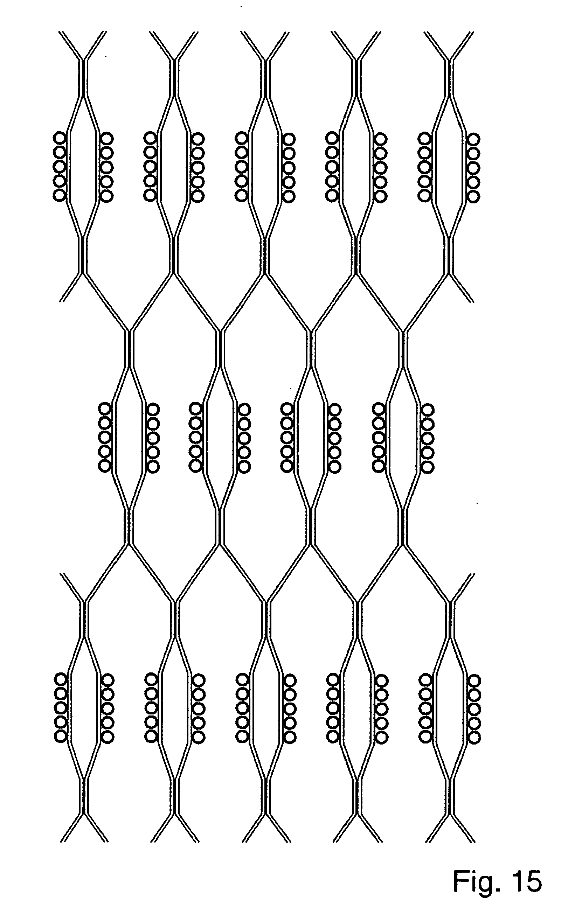

Also one can consider the structure as a wavelength selective switch in which the desired wavelengths will be switched to the desired output channel. One can switch different wavelengths in a single device as shown in Fig 14. This can be used in wavelength routers as depicted in **Fig. 15.** Fig. 15 shows a section of a wavelength router which comprises a plurality of single devices as of Fig. 14, connected to a switch network as schematically shown in Fig. 15. For reasons of clarity, the electrodes are not shown in Fig. 15. A wavelength router is a device in which optical signals of different wavelength can be routed, in a wavelength selective manner from any input waveguide (in the figure for example at the bottom) to any output waveguide (in the figure on a level - or stage - above the shown topmost level). Using the optical circuit as shown in Fig.15 one can achieve this function. Using the fabricated thin films it is possible to make this wavelength router. Notice that the number of switching stages must be equal to the number of input waveguide so that one can switch from any input waveguide to any output waveguide.

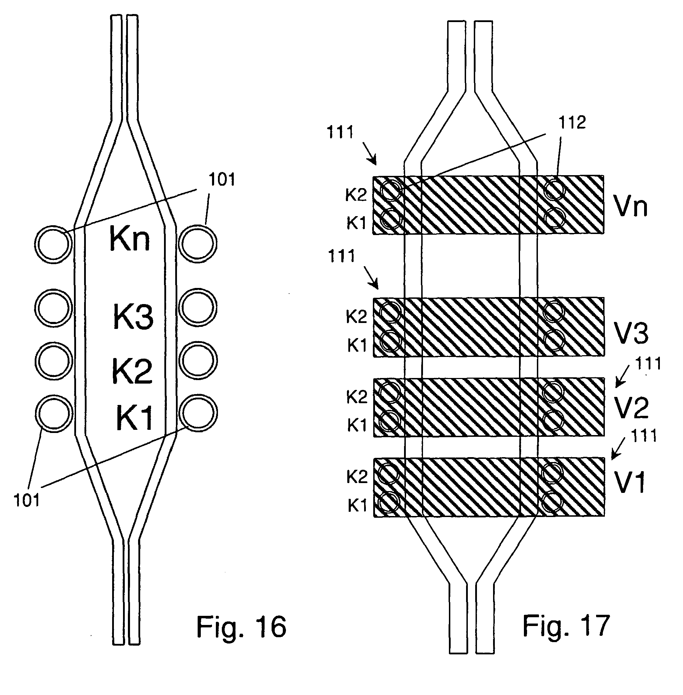

Notice that the micro-resonator as described above is a wavelength selective filter. Also more complicated filters with specific characteristics can be fabricated by coupling several micro-resonator pairs with different coupling constants and different phase differences to achieve different contributions to a tailored broadband filter. Such a broadband filter - for example corresponding to a square function filter - may ultimately help to achieve lower cross talk between adjacent channels when radiation of not only one frequency is to be switched. These filters can be in the form of the device shown in **Fig. 16,** where the K1, K2, K3,... Kn denote different coupling constants of the micro-resonator pairs 101. Notice that any desirable transfer function can be realized by the sum or difference of two all-pass filters. Using the device shown in Fig 16 and by carefully adjusting the coupling coefficient one can achieve a desirable transfer function for filtering applications.

This principle may be combined with the principle explained referring to Fig.14: The phase changes brought about by the micro-resonator pairs may be switched on and off if they are caused by changes of refractive index in one (or both) micro-resonators of a pair due to a voltage applied to an electrode. A switch may comprise several groups of resonator pairs with different coupling constants and for different phase changes as shown in **Fig. 17.** There, every group 111 of resonator pairs - constituting a switchable filter for a given frequency band - for reasons of simplicity only comprises two pairs 112 characterized by coupling constants K1, K2. In reality, groups of more filter pairs, with arbitrary filter constants, may be chosen. In the shown embodiment, each group of filter pairs comprises one common electrode for applying a voltage V1, V2, ... Vn; however, electrodes for each filter pair may be provided individually.

Multi-frequency switches as shown in Fig. 17 may be combined to routing networks as in Fig. 15.

Finally one can change the refractive index of the waveguide periodically and couple the light out of the waveguide made by the above described method. **Fig 18** shows the device concept. An electro-optic micro-resonator 121 is considered. A periodic field is created by applying a voltage to the electrodes 122, 123 of this device. The electrodes are arranged in a manner that the positive and the negative electrode on the ring resonator alternate in a regular sequence, for example by being formed as shown in Fig. 18. The periodic field thus resulting induces a periodic index change in the core of the micro-resonator. This index change will couple the light out of the micro-resonator. This is similar to a grating coupler for a straight wave-guide. Notice that this grating is induced through an electro-optic effect. Hence one can induce the grating very rapidly. So it is possible to make an electro-optic loss induced switch. One can use this effect to change the losses for micro-resonators. Also the introduction of losses is important for coupled cavity resonators. To achieve a precise transfer function for coupled cavity resonators one needs to achieve a precise resonance wavelength and precise coupling. The resonance wavelength can be easily tuned using the electro-optic effect. However the coupling cannot be adjusted after the device is fabricated. However by introduction of losses into the cavity one can compensate for the inaccuracy in the coupling coefficients. By the method introduced in this invention one can tune both losses and resonance wavelength using electro-optic effect. This is very useful to achieve coupled cavity devices.

Using a perturbative method one can calculate the coupling between the guided modes and radiation modes in micro-ring resonators. Assuming that the perturbation due to index change is given by:

$$\delta n_{co}(r,\varphi) = \delta n \exp(im\varphi) \qquad\qquad (8)$$

where $n_{co}$ is the core index, $m$ is the number of periods of electrodes and $\delta n$ is the electro-optic index change. Also assuming the electric filed for guided mode is given by:

$$E_z(r,\varphi) = \Phi(r)e^{j\beta\varphi} \qquad\qquad (9)$$

Where $\Phi(r)$ is the filed profile and $\beta$ is an integer number for resonance modes, one can show that the radiated power is given by:

$$P_{rad} = \frac{1}{8}\sqrt{\frac{\varepsilon_0}{\mu_0}}k_0^3(2\pi)^2(\int_0^R J_{\beta-m}(-n_{cl}k_0r')(2n_{co}\delta n)\Phi(r')dr')^2 \qquad (10)$$

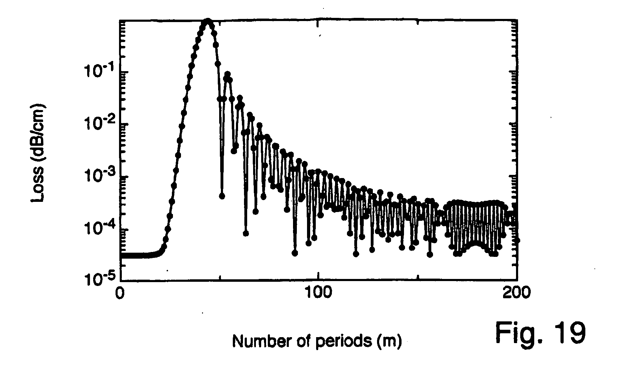

Where $J$ is the Bessel function and $n_{cl}$ is the cladding refractive index. **Fig 19** shows the calculated radiated power for a micro-resonator as a function of the number of periods for the electrodes $m$. The micro-resonator is assumed to have an outer diameter of $29\mu$m, core index of 1.6, cladding index of 1.3 and the optical wavelength is equal to $1.55\mu$m. The electro-optic coefficient is assumed to be 30pm/V. As it can be seen from Fig. 19, for m very small the losses are limited by leakage losses. By increasing the m further the losses rapidly increase since the guided mode matches to the first radiation mode. By increasing m further the losses decrease since the overlap integral between the guided modes and radiation modes decreases. It is interesting to note that by applying $10V/\mu$m it is possible to induce 2dB/cm loss. Notice that the losses increase as a square function of the index change. So by applying $20V/\mu$m the losses are as high as 4dB/cm. This value is very high and can be used in practical electro-optic micro-resonator to make switches or to compensate for the in accuracy in the coupling in multi-cavity micro-ring resonators.

Notice that all the required functions in a multi-wavelength communication system are realized with this single technology. The generation (laser), amplification, switching and modulation and filtering can be all realized using the described thin films. Also polarization sensitive devices can be made using the ferroelectric crystal waveguide described as well by choosing the right configuration.

## Claims

1. An optical device with two waveguide branches (62, 63), the first branch being coupled to a first micro-resonator (61, 71), and the second branch being coupled to the same micro-resonator (61) or to a second micro-resonator (72) different from the first micro-resonator, wherein waveguide cores of the waveguide branches and the micro-resonator(s) comprise a ferroelectric material (22, 54) on a first substrate (12, 53),
said ferroelectric material having been transferred from a ferroelectric crystal (1) by a method comprising the steps of providing said ferroelectric crystal, of irradiating a first surface of said ferroelectric crystal with ions so that a damaged layer (3) is created underneath said first surface, of bonding a block of material including said first substrate to said ferroelectric crystal to create a bonded element, wherein an interface is formed between said first surface and a second surface of said block, and of heating the bonded element and separating it at the damaged layer, so that a ferroelectric crystal layer remains supported by the first substrate,
wherein at least one branch and/or a micro-resonator coupled to it comprises an electrode (58) for influencing the index of refraction of the ferroelectric material, the electrode being formed in a layer parallel to the ferroelectric crystal layer and being positioned between the first substrate and the ferroelectric crystal layer.

2. The device according to claim 1, wherein said method includes the step of, prior to bonding the block to the ferroelectric crystal, fabricating said block by providing the first substrate, and applying a layer of electrically conducting material to it for forming said electrode (58).

3. The device according to claim 2, wherein the fabricating of said block further comprises the step of applying a dielectric layer (11, 56) to said layer of electrically conducting material, said dielectric layer forming said second surface.

4. The device according to any one of the previous claims, wherein the ferroelectric crystal is a $LiNbO_3$ or $LiTaO_3$ or $KNbO_3$ crystal.

5. The device according to any one of the previous claims, wherein said block comprises a second ferroelectric crystal, said second ferroelectric crystal preferably being a $LiNbO_3$ or $LiTaO_3$ or $KNbO_3$ crystal.

6. The device according to any one of the previous claims, wherein material at the second surface has an index of refraction that is lower than the index of refraction of said ferroelectric crystal by at least 10%, and wherein said material is preferably a silicon oxide.

7. The device according to any one of the previous claims, wherein the method comprises the step of chemical mechanical polishing of the first substrate prior to the bonding.

8. The device according to any one of the previous claims wherein the method comprises the step of annealing and/or polishing the ferroelectric crystal layer after the separating step.

9. The device according to any one of the previous claims, wherein the ferroelectric crystal is a bulk ferroelectric crystal.

10. The device according to any one of the previous claims being a wavelength selective switch.

11. The device according to any one of claims 1-9 being an optical wavelength selective filter.

12. The device according to claim 11 comprising a plurality of micro-resonator pairs or groups of micro-resonator pairs, each micro-resonator pair comprising a micro-resonator coupled to one branch and one micro-resonator coupled to the other branch, each micro-resonator pair or group of micro-resonator pairs comprising an electrode (52, 75) for influencing the index of refraction of the ferroelectric material, the different electrodes being separated from each other.

13. A dynamic wavelength router for routing optical signals of different wavelengths comprising a plurality of devices according to claim 12 connected to each other network-like.

14. An integrated optoelectronic device comprising a device according to any one of claims 1-12.

15. The integrated optoelectronic device according to claim 14 further comprising a parametric amplifier or frequency doubling device, fabricated by using a method of transferring ferroelectric material from a ferroelectric crystal (1) by a method comprising the steps of providing said ferroelectric crystal, of irradiating a first surface of said ferroelectric crystal with ions so that a damaged layer (3) is created underneath said first surface, of bonding a block of material including said first substrate to said ferroelectric crystal to create a bonded element, wherein an interface is formed between said first surface and a second surface of said block, and of heating the bonded element and separating it at the damaged layer, so that a ferroelectric crystal layer remains supported by the first substrate, the paramateric amplifier or frequency doubling device comprising a waveguide formed by a layered structure and a cladding, wherein the layered structure comprises at least two layers of a ferroelectric material arranged adjacent to each other in a layer sequence, wherein the spontaneous polarization of neighboring layers of the layer sequence differs.

16. The integrated optoelectronic device according to claim 15, wherein the layered structure comprises exactly three layers of one ferroelectric material.

17. A integrated optoelectronic device according to claim 15 or 16, wherein the spontaneous polarization of neighboring layers in the layer sequence is opposed.

18. The integrated optoelectronic device according to any one of claims 15-17, wherein the thickness of one layer of the layered structure is correlated to the waveguide configuration in a manner that a higher than fundamental mode has a node close to an interface between two adjacent layers.

19. The integrated optoelectronic device according to any one of claims 15-18, wherein the dimensions of the waveguide are chosen such that the waveguide contribution to the chromatic dispersion and the chromatic dispersion contributed by the ferroelectric material compensate each other in a certain wavelength range.

20. The integrated optoelectronic device according to any one of claims 14 to 19, comprising a waveguide formed by a layered structure and a cladding and further comprising electrodes with a periodic pattern, so that the waveguide core may be poled periodically to achieve quasi phase matching for frequency doubling or parametric amplification.

**Patentansprüche**

1. Optische Vorrichtung mit zwei Wellenleiter-Armen (62, 63), wobei der erste Arm an einen ersten Mikroresonator (61, 71) gekoppelt und der zweite Arm an denselben Mikroresonator (61) oder an einen zweiten, sich vom ersten Mikroresonator unterscheidenden Mikroresonator (72) gekoppelt ist, wobei die Wellenleiterkerne der Wellenleiterarme und die Mikroresonatoren ein ferroelektrisches Material (22, 54) auf einem ersten Substrat (12, 53) umfassen, wobei das genannte ferroelektrische Material von einem ferroelektrischen Kristall (1) übertragen worden ist, mittels eines Verfahrens, welches die Schritte des Bereitstellens des ferroelektrischen Kristalls, des Bestrahlens einer ersten Oberfläche des ferroelektrischen Kristalls mit Ionen, derart, dass eine beschädigte Schicht (3) unter der ersten Oberfläche gebildet wird, des Bindens eines das erste Substrat enthaltenden Materialblockes an den ferroelektrischen Kristall, um ein verbundenes Element zu schaffen, wobei eine Schnittstelle zwischen der ersten Oberfläche und einer zweiten Oberfläche des Blockes gebildet wird, und des Erhitzens des gebundenen Elementes und dessen Teilung bei der beschädigten Schicht, derart, dass eine durch das erste Substrat abgestützte ferroelektrische Kristsallschicht zurückbleibt,
wobei mindestens ein Arm und/oder ein daran gekoppelter Mikroresonator eine Elektrode (58) zur Beeinflussung des Brechungsindex des ferroelektrischen Materials umfasst, wobei die Elektrode in einer zur ferroelektrischen Kristallschicht parallelen Schicht gebildet und zwischen dem ersten Substrat und der ferroelektrischen Kristallschicht angeordnet ist.

2. Vorrichtung gemäss Anspruch 1, wobei die Vorrichtung, vor dem Binden des Blocks an den ferroelektrischen Kristall, den Schritt der Herstellung des Blocks durch Bereitstellen des ersten Substrates und daran Anbringen einer Schicht von elektrisch leitendem Material zur Bildung der Elektrode (58) umfasst.

3. Vorrichtung gemäss Anspruch 2, wobei die Herstellung des Blocks weiter den Schritt des Anbringens einer dielektrischen Schicht (11, 56) auf die Schicht elektrisch leitenden Materials umfasst, wobei die genannte dielektrische Schicht die genannte zweite Oberfläche bildet.

4. Vorrichtung gemäss irgend einem der vorangehenden Ansprüche, wobei der ferroelektrische Kristall ein $LiNbO_3$ oder $LiTaO_3$ oder $KNbO_3$ Kristall ist.

5. Vorrichtung gemäss irgend einem der vorangehenden Ansprüche, wobei der genannte Block einen zweiten ferroelektrischen Kristall umfasst, wobei der genannte zweite ferroelektrische Kristall vorzugsweise ein $LiNbO_3$ oder $LiTaO_3$ oder $KNbO_3$ Kristall ist.

6. Vorrichtung gemäss irgend einem der vorangehenden Ansprüche, wobei das Material an der zweiten Oberfläche einen Brechungsindex aufweist, welcher um mindestens 10% tiefer ist als der Brechungsindex des genannten ferroelektrischen Kristalls und wobei das genannte Material vorzugsweise ein Silikonoxid ist.

7. Vorrichtung gemäss irgend einem der vorangehenden Ansprüche, wobei das Verfahren den Schritt des chemisch mechanischen Polierens des ersten Substrates vor der Bindung umfasst.

8. Vorrichtung gemäss irgend einem der vorangehenden Ansprüche, wobei das Verfahren den Schritt des Tempems und/oder Polierens der ferroelektrischen Kristallschicht nach dem Trennschritt umfasst.

9. Vorrichtung gemäss irgend einem der vorangehenden Ansprüche, wobei der ferroelektrische Kristall ein ferroelektrischer ‚Bulk'-Kristall ist.

**10.** Vorrichtung gemäss irgend einem der vorangehenden Ansprüche, wobei sie ein Wellenlängen-selektiver Schalter ist.

**11.** Vorrichtung gemäss irgend einem der Ansprüche 1-9, wobei sie ein Wellenlängen-selektiver optischer Filter ist.

**12.** Vorrichtung gemäss Anspruch 11, wobei sie eine Vielzahl von Mikroresonatorpaaren oder -gruppen Mikroresonatorpaaren aufweist, wobei jedes Mikroresonatorpaar mit einem Mikroresonator an den einen Arm und mit dem anderen Mikroresonator an den anderen Arm gekoppelt ist, wobei jedes Mikroresonatorpaar oder jede Mikroresonatorgruppe eine Elektrode (52, 75) zur Beeinflussung des Brechungsindexes des ferroelektrischen Materials aufweist, wobei die verschiedenen Elektroden voneinander getrennt sind.

**13.** Dynamische Wellenlängen-Weiche zur Steuerung von optischen Signalen verschiedener Wellenlängen, welcher eine Vielzahl von netzwerkartig miteinander verbundenen Vorrichtungen gemäss Anspruch 12 aufweist.

**14.** Intergrierte optoelektronische Vorrichtung, welche eine Vorrichtung gemäss irgend einem der Ansprüche 1-12 aufweist.

**15.** Integrierte optoelektronische Vorrichtung gemäss Anspruch 14, welche weiter einen parametrischen Verstärker oder eine Frequenzverdoppelungsvorrichtung aufweist, hergestellt durch Verwendung eines Verfahrens der Übertragung von ferroelektrischem Material von einem ferroelektrischen Kristall (1) durch ein Verfahren, welches die Schritte des Bereitstellens des genannten ferroelektrischen Kristalls, des Bestrahlens einer ersten Oberfläche des genannten ferroelektrischen Kristalls mit Ionen, derart, dass eine beschädigte Schicht unterhalb der genannten ersten Schicht gebildet wird, des Bindens eines das genannte erste Substrat einschliessenden Materialblockes an den genannten ferroelektrischen Kristall, um ein verbundenes Element zu bilden, wobei eine Schnittstelle zwischen der genannten ersten Oberfläche und einer zweiten Oberfläche des genannten Blockes gebildet wird, und des Erhitzens des verbundenen Elements und dessen Abtrennung bei der beschädigten Schicht, derart, dass eine durch das erste Substrat abgestützte ferroelektrische Kristsallschicht zurückbleibt, wobei der parametrische Verstärker oder die Frequenzverdoppelungsvorrichtung einen durch eine geschichtete Struktur und eine Umhüllung gebildeten Wellenleiter aufweist, wobei die geschichtete Struktur mindestens zwei in einer Schichtsequenz angeordnete anliegende Schichten eines ferroelektrischen Materials aufweist, wobei die spontane Polarisation der benachbarten Schichten der Schichtsequenz abweichend ist.

**16.** Integrierte optoelektronische Vorrichtung gemäss Anspruch 15, wobei die geschichtete Struktur genau drei Schichten desselben ferroelektrischen Materials aufweist.

**17.** Integrierte optoelektronische Vorrichtung gemäss Anspruch 15 oder 16, wobei die spontane Polarisation von benachbarten Schichten in der Schichtsequenz entgegengesetzt ist.

**18.** Integrierte optoelektronische Vorrichtung gemäss irgend einem der Ansprüche 15-17, wobei die Dicke einer Schicht der geschichteten Struktur mit der Wellenleiterkonfiguration korreliert, derart, dass ein vom Grundmodus verschiedener Modus einen Knotenpunkt nahe einer Schnittstelle von zwei anliegenden Schichten hat.

**19.** Integrierte optoelektronische Vorrichtung gemäss irgend einem der Ansprüche 15-18, wobei die Dimensionen des Wellenleiters derart gewählt sind, dass die Wellenleiterbeitrag zur chromatischen Dispersion und die vom ferroelektrischen Material beigetragene chromatische Dispersion einander in einem bestimmten Wellenlängenbereich kompensieren.

**20.** Integrierte optoelektronische Vorrichtung gemäss irgend einem der Ansprüche 14 bis 19, welche einen durch eine geschichtete Struktur und eine Umhüllung gebildeten Wellenleiter aufweist und weiter Elektroden mit einem periodischen Muster aufweist, derart, dass der Wellenleiterkern periodisch gepolt werden kann, um eine quasi-Phasenabstimmung für Frequenzverdoppelung oder parametrische Verstärkung zu erreichen.

**Revendications**

**1.** Dispositif optique qui présente deux branches (62, 63) de guide d'onde, la première branche étant reliée à un premier micro-résonateur (61, 71) et la deuxième branche au même micro-résonateur (61) ou à un deuxième micro-résonateur (72) différent du premier micro-résonateur, des âmes de guide d'onde des branches de guide d'onde et le ou les micro-résonateurs comprenant un matériau ferroélectrique (22n 54) sur un premier support (12, 53),

ledit matériau ferroélectrique ayant été transféré d'un cristal ferroélectrique (1) par un procédé qui comprend les étapes qui consistent à prévoir ledit cristal ferroélectrique, à irradier une première surface dudit cristal ferroélectrique à l'aide d'ions de manière à former une couche endommagée (3) en dessous de ladite première surface, à lier un bloc de matériau qui comprend lesdits premier support audit cristal ferroélectrique de manière à créer un élément lié, une interface étant ainsi formée entre ladite première surface et une deuxième surface dudit bloc, à chauffer l'élément lié et à le séparer par la couche endommagée de manière à ce qu'une couche de cristal ferroélectrique reste soutenue sur le premier support,

au moins une branche et/ou un micro-résonateur qui lui est relié comprenant une électrode (58) qui sert à agir sur l'indice de réfraction du matériau ferroélectrique, l'électrode étant formée dans une couche parallèle à la couche de cristal ferroélectrique et étant placée entre le premier substrat et la couche de cristal ferroélectrique.

2. Dispositif selon la revendication 1, dans lequel ledit procédé comprend les étapes qui consistent, avant la liaison du bloc au cristal ferroélectrique, à fabriquer ledit bloc en prévoyant le premier support et à appliquer une couche de matériau électriquement conducteur pour former ladite électrode (58).

3. Dispositif selon la revendication 2, dans lequel la fabrication dudit bloc comprend en outre l'étape qui consiste à appliquer une couche diélectrique (11, 56) sur ladite couche de matériau électriquement conducteur, ladite couche diélectrique formant ladite deuxième surface.

4. Dispositif selon l'une quelconque des revendications précédentes, dans lequel le cristal ferroélectrique est un cristal de $LiNbO_3$, de $LiTaO_3$ ou de $KNbO_3$.

5. Dispositif selon l'une quelconque des revendications précédentes, dans lequel ledit bloc comprend un deuxième cristal ferroélectrique, ledit deuxième cristal ferroélectrique étant de préférence un cristal de $LiNbO_3$, de $LiTaO_3$ ou de $KNbO_3$.

6. Dispositif selon l'une quelconque des revendications précédentes, dans lequel le matériau situé sur la deuxième surface a un indice de réfraction inférieur d'au moins 10 % à l'indice de réfraction dudit cristal ferroélectrique, ledit matériau étant de préférence un oxyde de silicium.

7. Dispositif selon l'une quelconque des revendications précédentes, dans lequel le procédé comprend l'étape de polissage mécanique-chimique du premier support avant la liaison.

8. Dispositif selon l'une quelconque des revendications précédentes, dans lequel le procédé comprend l'étape qui consiste à recuire et/ou à polir la couche de cristal ferroélectrique après l'étape de séparation.

9. Dispositif selon l'une quelconque des revendications précédentes, dans lequel le cristal ferroélectrique est un cristal ferroélectrique massif.

10. Dispositif selon l'une quelconque des revendications précédentes, qui forme un commutateur sélectif vis-à-vis de la longueur d'onde.

11. Dispositif selon l'une quelconque des revendications 1 à 9, qui forme un filtre optique sélectif vis-à-vis de la longueur d'onde.

12. Dispositif selon la revendication 11, qui comprend plusieurs paires de micro-résonateurs ou groupes de paires de micro-résonateurs, chaque paire de micro-résonateurs comprenant un micro-résonateur relié à une branche et un micro-résonateur relié à l'autre branche, chaque paire de micro-résonateurs ou groupe de paires de micro-résonateurs contenant une électrode (52, 75) qui agit sur l'indice de réfraction du matériau ferroélectrique, les différentes électrodes étant séparées les unes des autres.

13. Routeur dynamique de longueur d'onde qui achemine des signaux optiques de différentes longueurs d'onde et qui comprend plusieurs dispositifs selon la revendication 12 reliés les uns aux autres en réseau.

14. Dispositif optoélectronique intégré qui comprend un dispositif selon l'une quelconque des revendications 1 à 12.

15. Dispositif optoélectronique intégré selon la revendication 14, qui comprend en outre un amplificateur paramétrique ou un dispositif de doublement de fréquence fabriqués en utilisant un procédé de transfert de matériau ferroélectrique d'un cristal ferroélectrique (1) par un procédé qui comprend les étapes qui consistent à prévoir ledit cristal ferroélectrique, à irradier une première surface dudit cristal ferroélectrique à l'aide d'ions de manière à former une couche endommagée (3) en dessous de ladite première surface, à lier un bloc de matériau qui comprend lesdits premier support audit cristal ferroélectrique de manière à créer un élément lié, une interface étant ainsi formée entre ladite première surface et une deuxième surface dudit bloc, à chauffer l'élément lié et à le séparer par la couche endommagée de manière à ce qu'une couche de cristal ferroélectrique reste soutenue sur le premier support, l'amplificateur paramétrique ou le dispositif de doublement de fréquence comprenant un guide d'onde formé par une structure stratifiée et un placage, la structure stratifiée comprenant au moins deux couches de matériau ferroélectrique agencées en position adjacente l'une à l'autre dans une succession de couches, les polarisations spontanées des couches voisines de la séquence de couches étant différentes.

16. Dispositif optoélectronique intégré selon la revendication 15, dans lequel la structure stratifiée comprend exactement trois couches d'un matériau ferroélectrique.

17. Dispositif optoélectronique intégré selon les revendications 15 ou 16, dans lequel les polarisations spontanées de couches voisines de la séquence de couches sont opposées.

18. Dispositif optoélectronique intégré selon l'une quelconque des revendications 15 à 17, dans lequel l'épaisseur d'une couche de la structure stratifiée est reliée à la configuration de guide d'onde de manière à ce qu'un mode d'ordre plus élevé que le mode fondamental présente un noeud proche de l'interface entre deux couches adjacentes.

19. Dispositif optoélectronique intégré selon l'une quelconque des revendications 15 à 18, dans lequel les dimensions du guide d'onde sont sélectionnées de telle sorte que la contribution du guide d'onde à la dispersion chromatique et que la dispersion chromatique apportée par le matériau ferroélectrique se compensent mutuellement dans une certaine plage de longueur d'onde.

20. Dispositif optoélectronique intégré selon l'une quelconque des revendications 14 à 19, qui comprend un guide d'onde formé par une structure stratifiée et un placage et qui comprend en outre des électrodes à motif périodique de telle sorte que l'âme de guide d'onde puisse être polarisée périodiquement de manière à obtenir quasiment un accord de phase pour le doublement de fréquence ou l'amplification paramétrique.

Fig. 1

Fig. 2

Fig. 3a     Fig.3b

Fig. 4

Fig. 5a          Fig. 5b

Fig. 6

Fig. 7

Fig. 8

Fig. 11

21

+V

52

51

Fig. 9

63

+V

61

64

Fig. 10

62

Fig. 12

Fig. 14

Fig. 13

Fig. 18

Fig. 15

Fig. 16

Fig. 17

Fig. 19

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6593212 B